(19) Europäisches Patentamt
European Patent Office
Office européen des brevets

(11) **EP 3 093 882 B1**

(12) **EUROPEAN PATENT SPECIFICATION**

(45) Date of publication and mention
of the grant of the patent:
**17.02.2021 Bulletin 2021/07**

(51) Int Cl.:
***H01L 23/373*** *(2006.01)*     ***H01L 23/12*** *(2006.01)*
***H01L 23/36*** *(2006.01)*

(21) Application number: **14877890.5**

(22) Date of filing: **15.12.2014**

(86) International application number:
**PCT/JP2014/083083**

(87) International publication number:
**WO 2015/104954 (16.07.2015 Gazette 2015/28)**

(54) **ELECTRONIC CIRCUIT DEVICE**

ELEKTRONISCHE SCHALTVORRICHTUNG

DISPOSITIF DE CIRCUIT ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.01.2014   JP 2014003672**

(43) Date of publication of application:
**16.11.2016   Bulletin 2016/46**

(73) Proprietor: **Furukawa Electric Co. Ltd.**
**Tokyo 100-8322 (JP)**

(72) Inventors:
• **KOJIMA Naoyuki**
**Tokyo 100-8322 (JP)**
• **SATO Shunichiro**
**Tokyo 100-8322 (JP)**
• **HIKASA Kazuhito**
**Tokyo 100-8322 (JP)**
• **FUJIWARA Hidemichi**
**Tokyo 100-8322 (JP)**

(74) Representative: **Glück Kritzenberger**
**Patentanwälte PartGmbB**
**Hermann-Köhl-Strasse 2a**
**93049 Regensburg (DE)**

(56) References cited:
JP-A- H 104 156        JP-A- H0 551 271
JP-A- S5 852 832       JP-A- H10 125 821
JP-A- 2001 237 252     JP-A- 2004 014 589
JP-A- 2006 202 938     JP-A- 2006 319 146
JP-A- 2010 103 311     JP-A- 2012 531 728
US-A1- 2012 134 115    US-B2- 6 776 329

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present invention relates to electronic circuit devices.

Background Art

For a semiconductor device, such as a power semiconductor device, that produces a very large amount of heat when operated with a high frequency large current, it is necessary that a conductor layer at a lower side of the semiconductor device has an increased heat capacity to allow heat to escape quickly. To this end, it is proposed to increase a heat capacity of the conductor layer by increasing an area or a thickness of the conductor layer (e.g., see Patent Document 1). From Patent Document 2 an electronic circuit according to the preamble of claim 1 is known.

Document List

Patent Document(s)

Patent Document 1: Japanese Laid-Open Patent Publication No. 2003-188316
Patent Document 2: JP 2001 237252 A

Summary of Invention

Technical Problem

By increasing an area and a thickness of the conductor layer, a heat dissipating effect is improved. However, in a production process, when a temperature cycle in which the device is placed in a low temperature environment and thereafter in a high temperature environment is repeated, the substrate may crack along an interface between an insulating layer and the conductor layer due to a large difference between a coefficient of linear expansion of the insulating layer adjacent to the conductor layer and a coefficient of linear expansion of the conductor layer.

It is an object of the present invention to provide an electronic circuit device that can improve a heat dissipating effect of the conductor layer while suppressing an occurrence of a crack in the substrate that may occur along an interface between the insulating layer and the conductor layer.

Solution to Problem

The above mentioned problem is solved with an electronic circuit according to claim 1. Preferred embodiments of the invention are subject matter of the dependent claims.

According to the invention, the electronic circuit device comprises an insulating layer, a conductor layer provided on at least one face side of the insulating layer, and a heat generating element provided on a face of the conductor layer at a side opposite of the insulating layer via a joining layer. The conductor layer has a heat dissipating conductor layer located on a heat generating element side and a circuit layer located on the insulating layer side, and a shortest distance $l_1$ between a side end portion of the heat generating element and a side end portion of the heat dissipating conductor layer on a face of the heat dissipating conductor layer on the circuit layer side is greater than or equal to a thickness $t_1$ of the heat dissipating conductor layer.

The conductor layer has an intervening metal layer between the heat dissipating conductor layer and the circuit layer. According to the present invention, the intervening metal layer is a sintered body of metal particles and the intervening metal layer has a layer inner portion that is in contact with a face of the heat dissipating conductor layer and a layer outer portion that extends to surround a side edge of the heat dissipating conductor layer, and the layer outer portion has a porosity higher than a porosity of the layer inner portion.

The ratio [(B)/(A)] of the porosity (B) at an intermediate part in the thickness direction of the layer outer portion 23o to the porosity (A) at an intermediate part in the thickness direction of the inner portion 23i is 1.10 to 1.60, and the porosity (A) of the layer inner portion 23i is 10.5% to 20.0%.

As an embodiment of the present invention, it is preferable that the shortest distance $l_1$ between a side end portion of the heat generating element and a side end portion of the heat dissipating conductor layer on a face of the heat dissipating conductor layer on the circuit layer side is greater than or equal to twice the thickness $t_1$ of the heat dissipating conductor layer.

As an embodiment of the present invention, it is preferable that the following relationship holds:

$$L_e \geq 0.1 \times L_w/2,$$

where

$L_w$ is a distance of a longest diagonal of the circuit layer, and
$L_e$ is a shortest distance between an apex portion of the circuit layer and a side end portion of the heat dissipating conductor layer along the diagonal on a face of the circuit layer on the heat dissipating conductor layer side.

As an embodiment of the present invention, it is preferable that the shortest distance $l_1$ between a side end portion of the heat generating element and a side end portion of the heat dissipating conductor layer on a face of the heat dissipating conductor layer on the circuit layer side is less than or equal to four times the thickness $t_1$ of the heat dissipating conductor layer.

As an embodiment of the present invention, it is preferable that the face of the heat dissipating layer on the joining layer side has an area smaller than an area of the face of the heat dissipating conductor layer on the circuit layer side.

As an embodiment of the present invention, it is preferable that the heat dissipating conductor layer has a first conductor portion located on the circuit layer side and a second conductor portion located on the heat generating element side, and a shortest distance $l_2$ between the side end portion of the heat generating element and the side end portion of the second conductor portion on a face of the first conductor portion on the second conductor portion side is greater than or equal to twice the thickness $t_2$ ($t_2 < t_1$) of the second conductor portion.

As an embodiment of the present invention, it is preferable that the heat dissipating conductor layer has a thermal conductivity of 90 to 427 W/(m·K).

As an embodiment of the present invention, it is preferable that the heat dissipating conductor layer has a coefficient of linear expansion of 3 to 18 × $10^{-6}$/K.

Effects of Invention

In accordance with the present invention, the heat dissipating effect of the conductor layer can be improved while suppressing a substrate from cracking along an interface between the insulating layer and the conductor layer.

Brief Description of Drawings

[Fig. 1] Fig. 1 is a cross-sectional view of an electronic circuit device.
[Fig. 2] Fig. 2 is a plan view of an electronic circuit device.
[Fig. 3] Fig. 3 is a graph in which: a horizontal axis represents a ratio between the shortest distance between a side end portion of a heat generating element and a side end portion of a heat dissipating conductor layer to the thickness of the heat dissipating conductor layer; and a vertical axis represents an amount of temperature drop of the heat generating element after an elapse of a certain period of time.
[Fig. 4] Fig. 4 is a graph in which: a horizontal axis represents a ratio between a value obtained by multiplying a distance of the longest diagonal of the circuit layer by a coefficient 1/2 to a shortest distance between an apex portion of the circuit layer and a side end portion of the heat dissipating conductor layer along a diagonal on a face of the circuit layer on the heat dissipating conductor layer side; and a vertical axis represents the number of samples that did not show problems in the Temperature Cycling Test.
[Fig. 5] Fig. 5 is a cross-sectional view of another exemplary electronic circuit device.

Description of the Embodiments

A preferred embodiment of the present invention will be described below with reference to with the accompanying drawings. The embodiment described below is shown by way of example, and various embodiments are feasible within the scope of the present invention.

<Electronic Circuit Device>

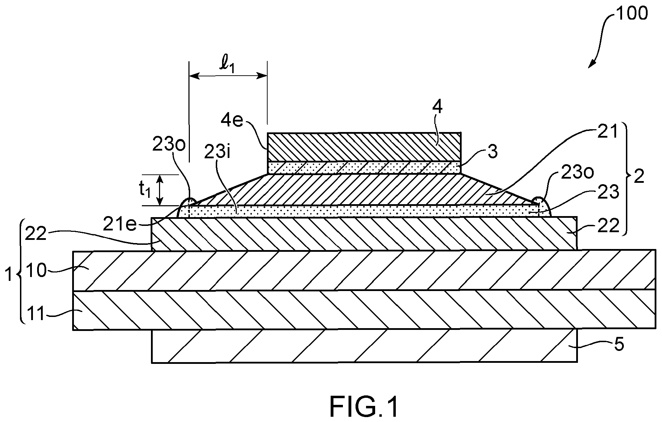

As shown in FIG. 1, an electronic circuit device 100 has, as a circuit board, a DBC (Direct Bonded Copper) substrate that has a ceramic insulating layer and a copper circuit layer directly bonded thereon. Here, the DBC substrate is given by way of example, and the substrate may be an active metal copper circuit board having a ceramic insulating layer and a copper circuit layer bonded thereon with a brazing material, i.e., AMC substrate (Active Metal Brazed Copper), or a DBA (Direct Brazed Aluminum) substrate having a ceramic insulating layer and an aluminum circuit layer bonded thereon.

The electronic circuit device 100 includes a circuit board 1 having a circuit layer 22 and a back-side conductor layer 11 on either main face of the insulating layer 10, a conductor layer 2, a joining layer 3, a heat generating element 4 and a heat dissipating device 5. The conductor layer 2 is laminated on one of the faces of the circuit board 1. The joining layer 3 is laminated on the conductor layer 2, and the heat generating element 4 is provided on the joining layer 3. The heat dissipating device 5 is provided on the other face of the circuit board 1.

(Circuit Board)

The circuit board 1 has the insulating layer 10, the back-side conductor layer 11 and the circuit layer 22.

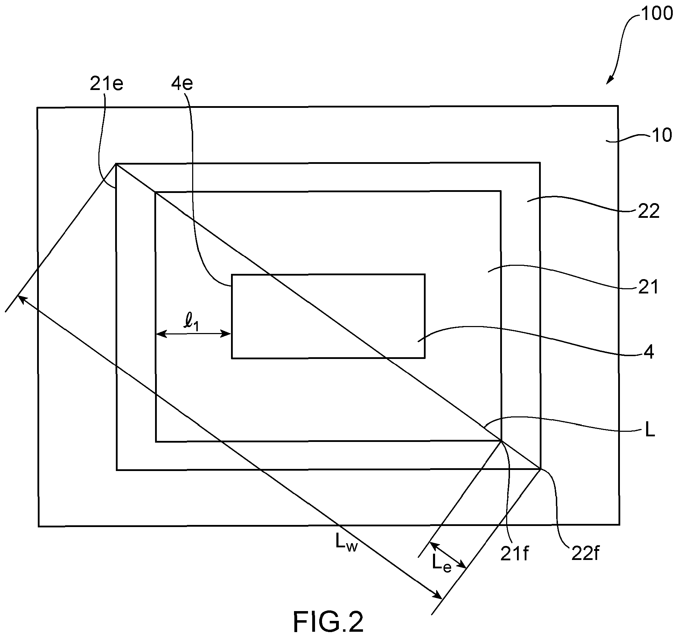

The insulating layer 10 is a constituent element of the circuit board 1, and as shown in FIG. 2, it is formed into a rectangular shape in a plan view and it is formed of an organic material or a ceramic. The ceramic employed herein may be, for example, a ceramic manufactured by forming a sheet of a powder material of one of $Al_2O_3$, AlN, $Si_3N_4$ and glass, a powder material of two or more of $Al_2O_3$, AlN, $Si_3N_4$ and glass, or a powder material composed primarily of $Al_2O_3$, AlN, $Si_3N_4$ and glass, with a binder component being blended as necessary, and thereafter firing the sheet. The insulating layer 10 composed of a ceramic may be smoothed as appropriate by, for example, polishing the surface with abrasive grains.

The organic material employed herein may be a material such as polyamide, epoxy and polyimide, or any material obtained by providing displacement plating capability or photosensitivity to such material. It is to be noted that materials which can be employed are not limited thereto.

The insulating layer 10 may be designed to have a thickness as appropriate, which is preferably 100 to 1000 $\mu$m, and by reducing the thickness of the insulating layer 10 to 100 $\mu$m to 300 $\mu$m, it is possible to decrease a thermal resistance of the electronic circuit device 100 from the heat generating element 4 to the heat dissipating device 5.

The back-side conductor layer 11 is a constituent element of the circuit board 1, and, as shown in FIG. 1, it is provided on a face of the insulating layer 10 that is opposite of a face of the insulating layer 10 on which the circuit layer 22 is provided, and it is formed to have a thickness balanced with, i.e., approximately the same thickness as, the circuit layer 22 to eliminate warping of the substrate. The back-side conductor layer 11 is preferably formed of a metal selected from a metallic element group consisting of Cu, Al, Ag and Au, an alloy of two or more metals selected from such metallic element group, or an alloy having a major component selected from such metallic element group.

The circuit layer 22 will be described along with the conductor layer 2.

(Conductor Layer)

The conductor layer 2 includes a heat dissipating conductor layer 21 located on the heat generating element 4 side, a circuit layer 22 located on the insulating layer 10 side, and an intervening metal layer 23 provided between the heat dissipating conductor layer 21 and the circuit layer 22.

The heat dissipating conductor layer 21 is preferably formed of a metal selected from a metallic element group consisting of Cu, Al, Ag and Au, an alloy of two or more metals selected from such metallic element group, or an alloy having a major component selected from such metallic element group.

The circuit layer 22 is preferably formed of a metal selected from a metallic element group consisting of Cu, Al, Ag and Au, an alloy of two or more metals selected from such metallic element group, or an alloy having a major component selected from such metallic element group. That is to say, considering the thermal stress that occurs in the intervening metal layer 23 due to differences in heat dissipating property and a coefficient of linear expansion, the heat dissipating conductor layer 21 is preferably composed of the same material as the circuit layer 22.

The heat dissipating conductor layer 21 and the circuit layer 22 may be separate layer bodies laminated to form the conductor layer 2, or may be formed integrally.

By providing the heat dissipating conductor layer 21, a heat capacity on a lower side of the heat generating element 4 can be increased, and thus an electronic circuit device having an excellent heat dissipating property can be obtained.

As shown in FIG. 2, each of the heat dissipating conductor layer 21 and the circuit layer 22 is formed to have a rectangular shape in a plan view. The heat dissipating conductor layer 21 is formed such that an area of the side facing the circuit layer 22 (lower face side) is smaller than an area of the side (upper face side) of the circuit layer 22 facing the heat dissipating conductor layer 21. The circuit layer 22 is formed such that an area of the side facing the insulating layer 10 (lower face side) is smaller than an area of the side (upper face side) of the insulating layer 10 facing the circuit layer 22.

Here, a shortest distance $l_1$ between a side end portion 4e of the heat generating element 4 and a side end portion 21e of the heat dissipating conductor layer 21 in the plane (along the plane) at a face of the heat dissipating conductor layer 21 on the circuit layer 22 side is greater than or equal to a thickness $t_1$ of the heat dissipating conductor layer 21. More specifically, it is preferable that the shortest distance $l_1$ is greater than or equal to twice the thickness $t_1$ of the heat dissipating conductor layer 21 and less than or equal to four times the thickness $t_1$ of the heat dissipating conductor layer 21.

The heat dissipating conductor layer 21 is chamfered at an end portion of the joining layer 3 side (upper face side), and formed such that an area of the face on the joining layer 3 side is smaller than an area of the face on the circuit layer 22 side. More specifically, the face of the heat dissipating conductor layer 21 on the joining layer 3 side is formed as a face having an area which is the same as or greater than an area of the face (lower face) of the joining layer 3 on the heat dissipating conductor layer 21 side, and, the face of the heat dissipating conductor layer 21 on the circuit layer 22 side is formed as a face having an area which is the same as or smaller than an area of the face (upper face) of the circuit layer 22 on the heat dissipating conductor layer 21 side. It is preferable that the heat dissipating conductor layer 21 has a thermal conductivity in a range of 90 to 427 W/ (m·k). Also, it is preferable that the heat dissipating conductor layer 21 has a coefficient of linear expansion of 3 to 18 $\times$ 10$^{-6}$/K, and further preferably, 3 to 10 $\times$ 10$^{-6}$/K.

The circuit layer 22 is formed to satisfy the relationship represented by Equation (1) below:

$$L_e \geq 0.1 \times L_w/2 \ \dots (1),$$

where

$L_w$ is a distance of a longest diagonal L that the circuit layer 22 itself has on a plane, and
$L_e$ is a shortest distance between an apex portion 22f of the circuit layer 22 and the side end portion 21f of the heat dissipating conductor layer 21 along the diagonal L on the face of the circuit layer 22 on the heat dissipating conductor layer 21 side.

The intervening metal layer 23 is a sintered body of metal particles, and has a large number of pores inside. The pore as used herein is a portion formed in the sintered body where the metal material does not exist, and formed by a gap between metal microparticles. Within the intervening metal layer 23, it is preferable that a volume fraction of the metal material is in a range of 50 to 99.999%. An organic material may be filled in pores at any ratio. More specifically, an organic material is filled in a single pore at any ratio, and a plurality of such pores may exist at any ratio. There may be pores completely filled with an organic material, and there may be pores that are not filled at all. As for the size of the pore, it is preferable that an average largest breadth is 10 nm to 1000 nm. If the pore size is less than 10 nm, when the metal material constituting the intervening metal layer 23 is about to expand by heat, or when a stress is produced which is due to differences in a coefficient of linear expansion between the insulating layer 10 and the circuit layer 22 or the heat dissipating conductor layer 21, the stress cannot be absorbed efficiently. If the pore size of greater than 1000 nm, an electric conductivity becomes low.

The intervening metal layer 23 is not limited to a sintered body of metal particles, and solder or silver paste may be used.

It is preferable that the metal microparticles have one or more metals among Cu, Ag, Au, Al, Ni, Sn, In and Ti as a major component. Particularly, Cu is preferable, since it is capable of suppressing migration. For ease of joining, materials may be the same as those of the heat dissipating conductor layer 21 and the circuit layer 22. It is preferable that the metal microparticles include particles with primary particles of an average particle diameter of 1 nm to 500 nm contained at a ratio of greater than or equal to 50 mass% and particles with primary particles of an average particle diameter of 0.5 $\mu$m to 50 $\mu$m contained at a ratio of less than or equal to 50 mass%.

An organic material filled in pores may be materials in general, such as polyamide, epoxy, polyimide, or polyhydric alcohol, or any material obtained by providing displacement plating capability or photosensitivity to such material. Prior to sintering metal microparticles, it is preferable to include a dispersing agent and a thickener, as well as metal microparticles, to facilitate handling. As a dispersing agent, polyhydric alcohol or the like may be used. As a thickener, polyvinylpyrrolidone or the like may be used.

As shown in FIG. 1, the intervening metal layer 23 has a layer inner portion 23i that is in contact with a lower face of the heat dissipating conductor layer 21 and a layer outer portion 23o that extends out of an outer periphery of the heat dissipating conductor layer 21, and the layer outer portion 23o has a porosity higher than the porosity of the layer inner portion 23i. By forming in this manner, the stress occurring at the joining interface between the heat dissipating conductor layer 21 and the circuit layer 22 is released, and the life of the joining can be improved. Also, heat dissipating property and conductivity are maintained and the joining reliability can be improved. The ratio [(B)/(A)] of the porosity (B) at an intermediate part in the thickness direction of the layer outer portion 23o to the porosity (A) at an intermediate part in the thickness direction of the inner portion 23i is 1.10 to 1.60, and the porosity (A) of the layer inner portion 23i is 10.5% to 20.0%.

It is preferable that the intervening metal layer 23 has a thickness of 5 to 500 $\mu$m. When it is less than 5 $\mu$m, the circuit layer 22 has a large crystalline size, and thus voids may occur locally and the surface may become coarse. When it is greater than 500 $\mu$m, a variation in a feeding thickness increases and a connection irregularity occurs. To ensure connection, it is particularly preferably 10 to 300 $\mu$m.

By providing the intervening metal layer 23, in a case where the metal material constituting the intervening metal layer 23 is about to expand by heat or when a stress due to differences in coefficient of linear expansion between the insulating layer 10 and the circuit layer 22 or the heat dissipating conductor layer 21 is produced, the stress can be absorbed and thus the stress on an end portion of the circuit layer 22 is released. Further, since the heat dissipating conductor layer 21 and the circuit layer 22 are joined by the intervening metal layer 23, thermal resistivity decreases and the heat dissipating property is good.

Note that, the above-mentioned distance is measured with a measurement microscope (manufactured by Mitutoyo Corporation, MF-A4020D). The thickness of the heat dissipating conductor layer is checked by measuring it with a micrometer prior to lamination.

(Joining Layer)

The joining layer 3 may be a sintered body of metal particles similar to the intervening metal layer 23 with the melting point after the sintering being 250 °C or higher. Particularly, a sintered body of Cu fine particles is preferable because of the joining ability with the heat dissipating conductor layer 21. By connecting the heat dissipating conductor layer 21 and the heat generating element 4 via a sintered body of metal particles, even if metal constituting the heat dissipating conductor layer 21 expands by heat, it is absorbed in pores, and an apparent elastic modulus decreases. Further, even if a stress is produced which is due to a difference in the coefficient of linear expansion of the heat generating element 4, the insulating layer 10, and the heat dissipating conductor layer 21, the stress is released since it is absorbed in pores. Therefore, peelings and cracks occurring between the heat generating element 4 and the heat dissipating conductor layer 21 can be reduced. The joining layer 3 is not limited to a sintered body of metal particles, and general die bonding materials such as solder and silver paste may be used.

(Heat Generating Element)

The heat generating element 4 is an electronic component of a semiconductor material, an element of a functional central part of an electronic component, and it is formed by being cut into chips having a rectangular shape in a plan view. The heat generating element 4 may be Si, SiC, GaN, GaAs, and particularly, SiC which is excellent in heat resistance is preferable.

(Heat Dissipating Device)

The heat dissipating device 5 is provided on a back-side conductor layer 11 which is a face opposite of the face of the insulating layer 10 of the circuit board 1 on which the conductor layer 2 is stacked. The heat dissipating device 5 may include a metal sheet or the like for dissipating heat generated by the heat generating element 4.

EXAMPLES

Hereinafter, the present invention will be described using Examples.

As a circuit board, a DBC substrate ((manufactured by Nippon Steel & Sumikin Electronics Devices, Inc, Cu (0.3 mmt)/$Al_2O_3$ (0.635 mmt)/Cu (0.3 mmt))) was prepared that includes a ceramic insulating layer and copper circuit layers joined on both faces of the insulating layer such that they are provided inwardly of an outer edge of the insulating layer.

Further, an intervening metal layer of copper paste was formed on the circuit layer, and a copper heat dissipating conductor layer was joined on the intervening metal layer. The intervening metal layer was formed as described below.

A metal mask of stainless steel having an opening of a size equivalent to the heat dissipating conductor layer and a thickness of 100 $\mu$mt was disposed at a position corresponding to the heat dissipating conductor layer, and a copper nano paste was printed using a metal squeegee. The copper nano paste used was prepared by dispersing copper particles of average particle diameter 20 nm as the metal microparticles in a dispersing agent (diethylene glycol) and adding a thickener (polyvinylpyrrolidone). Printing was performed on-contact with a squeegee pressure of 1 MPa, a squeegee angle of 5 degrees, and a squeegee speed of 5 mm/sec.

After printing, it was dried at 100 °C for 10 minute in the atmosphere, and thereafter a heat dissipating conductor layer was placed on the copper nano paste and joined by applying pressure and heat. Joining was performed using a vacuum pressing machine manufactured by Mikado Technos Co., Ltd. under a reduced pressure atmosphere, at 300 °C, with a pressure of 10 MPa and for a time period of 10 minutes. Further, the copper sheet side of the DBC substrate was placed on a teflon (registered trademark) sheet as a second material and joining was performed with a teflon (registered trademark) sheet being further provided on a conductor layer. At this point, as a sintered body layer, it had a thickness of 35 $\mu$m.

Here, as the heat dissipating conductor layer, copper sheets (oxygen free copper (C1020)) of different thicknesses $t_1$ of 0.2 mm, 0.3 mm, 1 mm, 2 mm, 3 mm, and 5 mm were used. Further, the heat dissipating conductor layers of different shortest distance $l_1$ within a range of 0.3 times to 10 times of the thickness $t_1$ were prepared, where $l_1$ is the shortest distance between a side end portion of the heat generating element provided on the heat dissipating conductor layer via the joining layer and a side edge of itself in a plane. In other words, a plurality of types of heat dissipating conductor layers with different size and thickness were prepared and joined on the circuit layer via the intervening metal layer.

A joining layer composed of a copper paste was formed on the heat dissipating conductor layer, and a heat generating element (a semiconductor device having a joining face metalized with Ti-Ni-Au alloy) of 5 mm square and a thickness of 230 $\mu$m was joined to the heat dissipating conductor layer via the joining layer. The copper paste used here is the same as the copper paste forming the intervening metal layer, and supplied for printing under the same condition using a metal mask having 5 mm square openings, and dried under the same condition, and, a semiconductor device was mounted thereon and joined by applying pressure and heat under the same condition.

As for the circuit layer, those having different longest diagonal length ($L_w$) of 10 mm, 20 mm, 30 mm, 40 mm, and 50 mm were prepared. The thickness of the heat dissipating conductor layer was checked by measurement using a micrometer prior to lamination. Also, regarding the size of the circuit layer and the heat dissipating conductor layer, those of different ratios within a range of 0.03 to 0.8 were prepared, which ratio being a value obtained by multiplying the distance of the longest diagonal $L_w$ of the circuit layer by a factor 1/20 to a shortest distance Le between an apex portion of the circuit layer along the diagonal on the face of the circuit layer on the heat dissipating conductor layer side and a side end portion of the heat dissipating conductor layer. That is to say, 40 types of circuit layers with different sizes were prepared and joined on the insulating layer. After the joining, these distances were measured with a magnification of 50 times using a measuring microscope (MF-A4020D manufactured by Mitutoyo Corporation).

<Evaluation Method>

Evaluation was performed based on following two endpoints.

(Heat Dissipating Property Test)

The heat generating element was heated by supplying power corresponding to heat generation of 114 W, while dissipating heat to a cooling thermal medium, which is kept at 20 °C with cooling water, through a heat dissipating device disposed at a back face side, until the temperature of the heat generating element has sufficiently increased and the temperature change per second has become less than or equal to ± 1 °C, and the temperature then was measured. This temperature measurement was carried out for a sample where $l_1 = 0$ and for samples prepared in Examples, and a difference $\Delta T$ between the temperature measured for the sample where $l_1 = 0$ and the temperature measured for each of the samples was calculated to evaluate heat dissipation. The temperature was measured three times for each sample and an average value of the three temperature measurements was used as the temperature measured for each sample.

(Temperature Cycling Test)

Temperature Cycling Test (TCT) was carried out for ten samples of each electronic circuit device provided with a heat generating element. Temperature Cycling Test is a test for evaluating resistance to temperature variation in which, in a single cycle, a sample is placed under an environment of 175 °C for 30 minutes and thereafter placed under an environment of -55 °C for 30 minutes (temperature increasing/decreasing rate is greater than or equal to 46 °C/minutes), and 1000 cycles are repeated. Thereafter, using an ultrasonic tester (manufactured by Hitachi Construction Machinery Co., Ltd., Mi-Scope) and a probe (model PQ2-13, 50MHz), an ultrasonic wave was irradiated from the semiconductor device side, and a gate was adjusted such that the ultrasonic wave is incident on a metal member surface from the back-side of the semiconductor device by reflection to measure the peeling. Based on this, the number of samples in which the conductor layer is peeled off from the insulating layer for an area of 20% or more and the number of samples having a defect such as a crack produced in the heat generating element were measured.

<Evaluation Result>

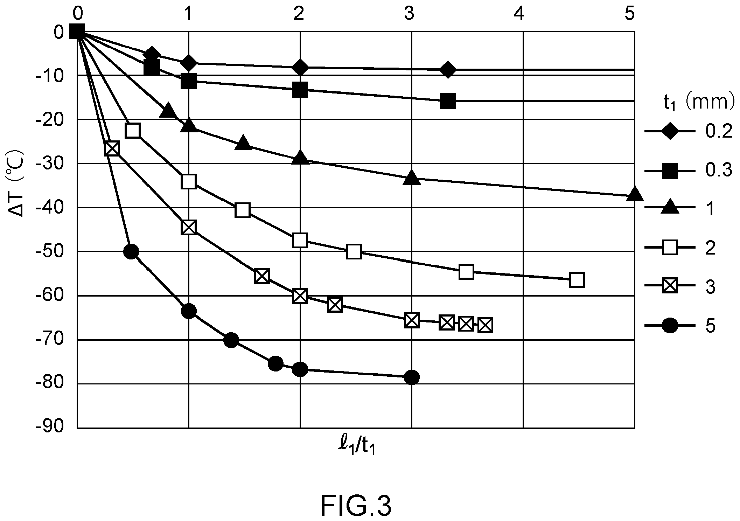

FIG. 3 is a graph in which a horizontal axis represents a ratio of the shortest distance $l_1$ between the side end portion of the heat generating element and the side end portion of the heat dissipating conductor layer to the thickness $t_1$ of the heat dissipating conductor layer, and a vertical axis represents an amount of temperature variation of the heat generating element after an elapse of a certain period of time (about 10 seconds). Note that, for samples having a thickness $t_1$ of 0.2 mm and 0.3 mm, the evaluation was carried out using those having the shortest distance $l_1$ which is greater than 0.5 times of thickness $t_1$, and in FIG. 3, it is a graph having a maximum when the value of $l_1/t_1$ is 5.

As shown in FIG. 3, in a case where a comparison is made between the heat dissipating conductor layers of the same thickness, as the shortest distance $l_1$ between the side end portion of the heat generating element and the side end portion of the heat dissipating conductor layer increases, the temperature after a certain period of time (about 10 seconds) is low, and it can be seen that the heat dissipating effect is great.

When the shortest distance $l_1$ is greater than the thickness $t_1$ of the heat dissipating conductor layer ($l_1/t_1 \geq 1$), it can be seen that beyond this point ($l_1/t_1 = 1$), the temperature largely decreases and the heat dissipating effect is high for heat dissipating conductor layers of any thickness. Further, it can be seen that when the shortest distance $l_1$ is greater than twice the thickness $t_1$, ($l_1/t_1 \geq 2$), the heat dissipating effect is even higher. Also, when the shortest distance $l_1$ was greater than 4 times the thickness $t_1$ ($l_1/t_1 > 4$), not much heat dissipating effect was observed, and thus it was seen that the shortest distance $l_1$ is preferably less than or equal to 4 times the thickness $t_1$ to avoid the substrate from becoming bulky.

Next, in a case where the ratio of the shortest distance $l_1$ between the side end portion of the heat generating element and the side end portion of the heat dissipating conductor layer to the thickness $t_1$ of the heat dissipating layer is the same, the temperature after a certain period of time becomes lower as the thickness of the heat dissipating conductor layer becomes greater, and it can be seen that the heat dissipating effect is great.

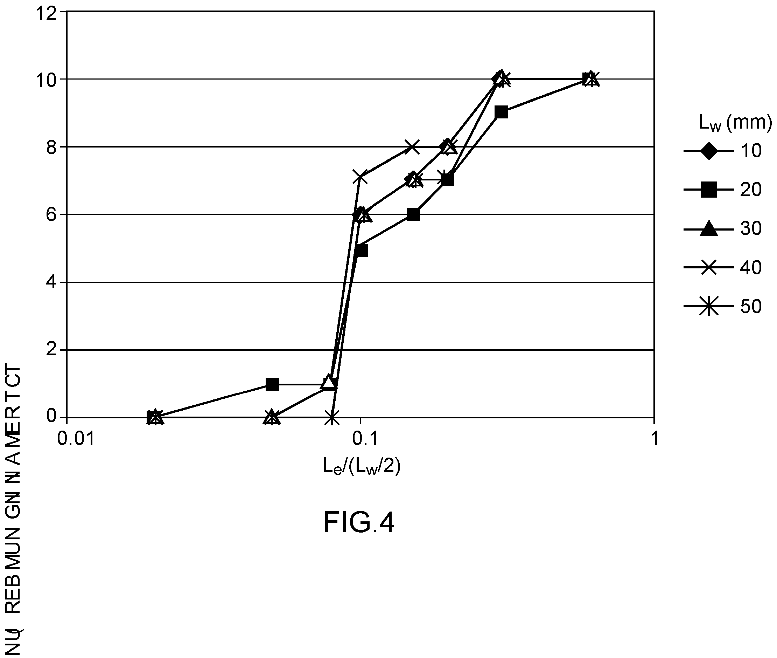

FIG. 4 is a graph in which a horizontal axis represents a ratio between a value obtained by multiplying a distance of the longest diagonal $L_w$ of the circuit layer by a coefficient 1/2 to a shortest distance $L_e$ between an apex portion of the circuit layer and a side end portion of the heat dissipating conductor layer along a diagonal on a face of the circuit layer on the heat dissipating conductor layer side, and a vertical axis represents the number of samples that did not show problems in the Temperature Cycling Test.

As shown in FIG. 4, when the shortest distance $L_e$ is greater than or equal to the length corresponding to 1/20 of the distance $L_w$ of the longest diagonal ($\{L_e/(L_w/2)\} \geq 0.1$), a number of samples that did not show problems in Temperature Cycling Test largely increases, and it can be seen that resistance to temperature variation improves.

<Function and Effect of the Embodiment>

As described above, according to an electronic circuit device 100 having the above-mentioned configuration, heat produced in the heat generating element 4 transfers to the conductor layer 2, and a range of diffusion is mainly within a range of approximately 45° against a straight line forming right angles with the face of the substrate. Here, since the shortest distance 11 between the side end portion 4e of the heat generating element 4 and the side end portion 21e of the heat dissipating conductor layer 21 on the face of the heat dissipating conductor layer 21 on the circuit layer 22 side is the same as the thickness $t_1$ or longer than the thickness $t_1$ of the heat dissipating conductor layer 21, diffusion of heat transferring from the heat generating element 4 is transferred to the heat dissipating conductor layer 21 without being blocked at the side face of the heat dissipating conductor layer 21, and the heat is dissipated. Thus, the heat dissipating effect of the heat dissipating conductor layer 21 can be improved while suppressing the cracking of the insulating layer 10 along an interface with the conductor layer 2.

Further, by forming the heat dissipating conductor layer 21 to have the shortest distance $l_1$ between the side end portion of the heat generating element 4 and the side end portion of the heat dissipating conductor layer 21 that is greater than or equal to twice the thickness $t_1$ of the heat dissipating conductor layer 21 and less than or equal to four times the thickness $t_1$ of the heat dissipating conductor layer 21, the heat dissipating effect can be improved with a smaller size.

Further, by forming the heat dissipating conductor layer 21 and the circuit layer 22 such that the shortest distance $L_e$ between the apex portion of the circuit layer 22 and the side end portion of the heat dissipating conductor layer 21 along the diagonal on the face of the circuit layer 22 on the heat dissipating conductor layer 21 side is greater than or equal to a length corresponding to 1/20 of the longest diagonal, in other words, to satisfy the relationship $L_e \geq 0.1 \times L_w/2$, the cracking of the heat dissipating conductor layer 21 along an interface with the circuit layer 22 can be suppressed.

Further, by chamfering an outer edge of the upper face of the heat dissipating conductor layer 21, adhesion of the resin during the molding of the electronic circuit device 100 improves.

Further, by providing the intervening metal layer 23 including a sintered body of the metal particles between the heat dissipating conductor layer 21 and the circuit layer 22, a stress occurring at an interface between the two layers is released, and peeling of the layers can be suppressed.

Further, with the porosity of the layer outer portion 23o in the intervening metal layer 23 being greater than the porosity of the layer inner portion 23i, the stress occurring in at a joining interface between the heat dissipating conductor layer 21 and the circuit layer 22 can be released, and the joining life can be improved, the heat dissipating property and conductivity are maintained and the joining reliability can be improved.

<Other>

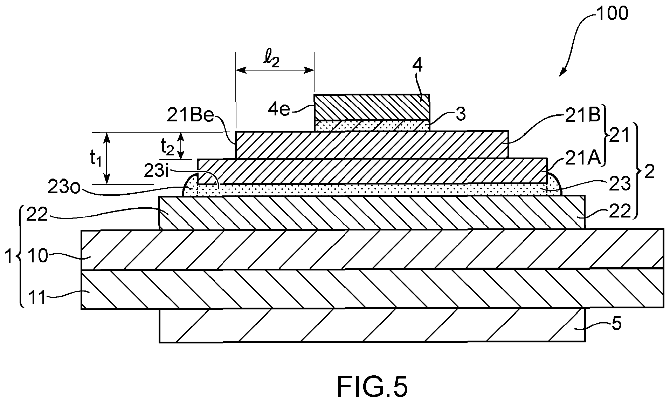

It is to be noted that the present invention is not limited to the embodiment described above. For example, as shown in FIG. 5, the heat dissipating conductor layer 21 may be configured to have a first conductor portion 21A located on the circuit layer 22 side and a second conductor portion 21B located on a heat generating element 4 side. In this case, it is preferable that the shortest distance $l_2$ between a side end portion 4e of the heat generating element 4 and a side end portion 21Be of the second conductor portion 21B on a face of the first conductor portion 21A on the second conductor portion 21B side is greater than or equal to double the thickness $t_2$ ($t_2 < t_1$) of the second conductor portion 21B.

Further, an intervening metal layer may be provided between the first conductor portion 21A and the second conductor portion 21B. Here, the intervening metal layer may be of a configuration similar to that of the intervening metal layer 23 provided between the heat dissipating conductor layer 21 and the circuit layer 22.

List of Reference Signs

1      circuit board,
2      conductor layer,
3      joining layer,
4      heat generating element,
5      heat dissipating device,
10     insulating layer,
11     back-side conductor layer,
21     heat dissipating conductor layer,
22     circuit layer,
23     intervening metal layer,
100    electronic circuit device

**Claims**

1.  An electronic circuit device (100) comprising:

    an insulating layer (10), a conductor layer (2) provided on at least one face side of the insulating layer, and a heat generating element (4) provided on a face of the conductor layer at a side opposite of the insulating layer via a joining layer (3),
    wherein the conductor layer has a heat dissipating conductor layer (21)
    located on a heat generating element side and a circuit layer located on the insulating layer side, and
    a shortest distance $l_1$ between a side end portion of the heat generating element and a side end portion of the heat dissipating conductor layer on a face of the heat dissipating conductor layer on the circuit layer side is greater than or equal to a thickness $t_1$ of the heat dissipating conductor layer, wherein the conductor layer has an intervening metal layer (23) between the heat dissipating conductor layer and the circuit layer, **characterized in that** the intervening metal layer is a sintered body of metal particles, that the intervening metal layer has a layer inner portion (23i) that is in contact with a face of the heat dissipating conductor layer and a layer outer portion (23o) that extends to surround a side edge of the heat dissipating conductor layer, and the layer outer portion has a porosity higher than a porosity of the layer inner portion, and that for the intervening metal layer (23) the ratio [(B)/(A)] of the porosity (B) at an intermediate part in the thickness direction of the layer outer portion to the porosity (A) at an intermediate part in the thickness direction of the inner portion is 1.10 to 1.60 and the porosity (A) of the layer inner portion is 10.5% to 20.0%..

2. The electronic circuit device according to claim 1, wherein the shortest distance $l_1$ between a side end portion of the heat generating element and a side end portion of the heat dissipating conductor layer on a face of the heat dissipating conductor layer on the circuit layer side is greater than or equal to twice the thickness $t_1$ of the heat dissipating conductor layer.

3. The electronic circuit device according to claim 1 or 2, wherein the following relationship holds:

$$L_e \geq 0.1 \times L_w/2,$$

where

$L_w$ is a distance of a longest diagonal of the circuit layer, and
$L_e$ is a shortest distance between an apex portion of the circuit layer and a side end portion of the heat dissipating conductor layer along the diagonal on a face of the circuit layer on the heat dissipating conductor layer side.

4. The electronic circuit device according to claim 2, wherein the shortest distance $l_1$ between a side end portion of the heat generating element and a side end portion of the heat dissipating conductor layer on a face of the heat dissipating conductor layer on the circuit layer side is less than or equal to four times the thickness $t_1$ of the heat dissipating conductor layer.

5. The electronic circuit device according to any one of claims 1 to 4, wherein the face of the heat dissipating layer on the joining layer side has an area smaller than an area of the face of the heat dissipating conductor layer on the circuit layer side.

6. The electronic circuit device according to any one of claims 1 to 5, wherein the heat dissipating conductor layer has a first conductor portion located on the circuit layer side and a second conductor portion located on the heat generating element side, and
a shortest distance $l_2$ between the side end portion of the heat generating element and the side end portion of the second conductor portion on a face of the first conductor portion on the second conductor portion side is greater than or equal to twice the thickness $t_2$ ($t_2 < t_1$) of the second conductor portion.

7. The electronic circuit device according to any one of claims 1 to 6, wherein the heat dissipating conductor layer has a thermal conductivity of 90 to 427 W/(m·K).

8. The electronic circuit device according to any one of claims 1 to 7, wherein the heat dissipating conductor layer has a coefficient of linear expansion of 3 to 18 $\times$ 10$^{-6}$/K.

**Patentansprüche**

1. Elektronische Schaltungsvorrichtung (100) aufweisend:

eine Isolierschicht (10), eine Leiterschicht (2), die an mindestens einer Flächenseite der Isolierschicht vorgesehen ist, und ein wärmeerzeugendes Element (4), das über eine Verbindungsschicht (3) an einer Fläche der Leiterschicht auf einer der Isolierschicht gegenüberliegenden Seite vorgesehen ist,
wobei die Leiterschicht eine wärmeableitende Leiterschicht (21) aufweist, welche auf einer Seite des wärmeerzeugenden Elements angeordnet ist, und eine Schaltungsschicht, welche auf der Seite der Isolierschicht angeordnet ist, und
ein kürzester Abstand $l_1$ zwischen einem seitlichen Endabschnitt des wärmeerzeugenden Elements und einem seitlichen Endabschnitt der wärmeableitenden Leiterschicht an einer Fläche der wärmeableitenden Leiterschicht auf der Seite der Schaltungsschicht größer oder gleich einer Dicke $t_1$ der wärmeableitenden Leiterschicht ist,
wobei die Leiterschicht eine zwischenliegende Metallschicht (23) zwischen der wärmeableitenden Leiterschicht und der Schaltungsschicht aufweist,
**dadurch gekennzeichnet, dass** die zwischenliegende Metallschicht ein Sinterkörper aus Metallpartikeln ist, dass die zwischenliegende Metallschicht einen inneren Schichtabschnitt (23i) aufweist, welcher mit einer Fläche der wärmeableitenden Leiterschicht in Kontakt ist, und einen äußeren Schichtabschnitt (23o), welcher sich derart erstreckt, dass er eine Seitenkante der wärmeableitenden Leiterschicht umgibt, und der äußere Schichtabschnitt eine Porosität aufweist, welche höher ist als eine Porosität des inneren Schichtabschnitts, und dass für die zwischenliegende Metallschicht (23) das Verhältnis [(B)/(A)] der Porosität (B) an einem mittleren Teil in der Dickenrichtung des äußeren Schichtabschnitts zur Porosität (A) an einem mittleren Teil in der Dickenrichtung des inneren Abschnitts 1,10 bis 1,60 beträgt und die Porosität (A) des inneren Schichtabschnitts 10,5 % bis 20,0 % beträgt.

2. Elektronische Schaltungsvorrichtung nach Anspruch 1, wobei der kürzeste Abstand $l_1$ zwischen einem seitlichen Endabschnitt des wärmeerzeugenden Elements und einem seitlichen Endabschnitt der wärmeableitenden Leiterschicht an einer Fläche der wärmeableitenden Leiterschicht auf der Seite der Schaltungsschicht größer oder gleich dem Doppelten der Dicke $t_1$ der wärmeableitenden Leiterschicht ist.

3. Elektronische Schaltungsvorrichtung nach Anspruch 1 oder 2, wobei das folgende Verhältnis gilt:

$$L_e \geq 0{,}1 \times L_w/2,$$

wobei

$L_w$ ein Abstand einer längsten Diagonale der Schaltungsschicht ist, und
$L_e$ ein kürzester Abstand zwischen einem Scheitelabschnitt der Schaltungsschicht und einem seitlichen Endabschnitt der wärmeableitenden Leiterschicht entlang der Diagonale an einer Fläche der Leiterschicht auf der Seite der wärmeableitenden Leiterschicht ist.

4. Elektronische Schaltungsvorrichtung nach Anspruch 2, wobei der kürzeste Abstand $l_1$ zwischen einem seitlichen Endabschnitt des wärmeerzeugenden Elements und einem seitlichen Endabschnitt der wärmeableitenden Leiterschicht an einer Fläche der wärmeableitenden Leiterschicht auf der Seite der Schaltungsschicht geringer oder gleich dem Vierfachen der Dicke $t_1$ der wärmeableitenden Leiterschicht ist.

5. Elektronische Schaltungsvorrichtung nach einem der Ansprüche 1 bis 4, wobei die Fläche der wärmeableitenden Schicht auf der Seite der Verbindungsschicht einen Flächeninhalt aufweist, welcher kleiner ist als ein Flächeninhalt der Fläche der wärmeableitenden Leiterschicht auf der Seite der Schaltungsschicht.

6. Elektronische Schaltungsvorrichtung nach einem der Ansprüche 1 bis 5, wobei die wärmeableitende Leiterschicht einen ersten Leiterabschnitt aufweist, welcher auf der Seite der Schaltungsschicht angeordnet ist, und einen zweiten Leiterabschnitt, welcher auf der Seite des wärmeerzeugenden Elements angeordnet ist, und
ein kürzester Abstand $l_2$ zwischen dem seitlichen Endabschnitt des wärmeerzeugenden Elements und dem seitlichen Endabschnitt des zweiten Leiterabschnitts an einer Fläche des ersten Leiterabschnitts auf der Seite des zweiten Leiterabschnitts größer oder gleich dem Doppelten der Dicke $t_2$ ($t_2 < t_1$) des zweiten Leiterabschnitts ist.

7. Elektronische Schaltungsvorrichtung nach einem der Ansprüche 1 bis 6, wobei die wärmeableitende Leiterschicht eine Wärmeleitfähigkeit von 90 bis 427 W/(m·K) aufweist.

8. Elektronische Schaltungsvorrichtung nach einem der Ansprüche 1 bis 7, wobei die wärmeableitende Leiterschicht einen linearen Ausdehnungskoeffizienten von 3 bis 18 $10^{-6}$/K aufweist.

**Revendications**

1. Dispositif de circuit électronique (100) comprenant :

une couche isolante (10), une couche conductrice (2) pourvue sur au moins une face de la couche isolante, et un élément de génération de chaleur (4) pourvu sur une face de la couche conductrice d'un côté opposé à la couche isolante via une couche de jonction (3),
dans lequel la couche conductrice comporte une couche conductrice de dissipation de chaleur (21) située d'un côté élément de génération de chaleur et une couche de circuit située du côté couche isolante, et
une distance la plus courte $l_1$ entre une portion d'extrémité latérale de l'élément de génération de chaleur et une portion d'extrémité latérale de la couche conductrice de dissipation de chaleur sur une face de la couche conductrice de dissipation de chaleur du côté couche de circuit est supérieure ou égale à l'épaisseur $t_1$ de la couche conductrice de dissipation de chaleur,
dans lequel la couche conductrice comporte une couche métallique intermédiaire (23) entre la couche conductrice de dissipation de chaleur et la couche de circuit,

**caractérisé en ce que** la couche métallique intermédiaire est un corps fritté de particules métalliques, **en ce que** la couche métallique intermédiaire comporte une portion de couche interne (23i) qui est en contact avec une face de la couche conductrice de dissipation de chaleur et une portion de couche externe (23o) qui s'étend pour entourer un bord latéral de la couche conductrice de dissipation de chaleur, et la portion de couche externe présente une porosité supérieure à la porosité de la portion de couche interne, et

**en ce que**, pour la couche métallique intermédiaire (23), le ratio [(B)/(A)] de la porosité (B) d'une partie intermédiaire en direction de l'épaisseur de la portion de couche externe par la porosité (A) d'une partie intermédiaire en direction de l'épaisseur de la portion interne est compris entre 1,10 et 1,60, et la porosité (A) de la portion de couche interne est comprise entre 10,5 % et 20,0 %.

2. Dispositif de circuit électronique selon la revendication 1, dans lequel la distance la plus courte $l_1$ entre une portion d'extrémité latérale de l'élément de génération de chaleur et une portion d'extrémité latérale de la couche conductrice de dissipation de chaleur sur une face de la couche conductrice de dissipation de chaleur du côté couche de circuit est supérieure ou égale à deux fois l'épaisseur $t_1$ de la couche conductrice de dissipation de chaleur.

3. Dispositif de circuit électronique selon la revendication 1 ou 2, dans lequel la relation suivante s'applique :

$$L_e \geq 0,1 \times L_w/2,$$

où

$L_w$ est la longueur de la diagonale la plus longue de la couche de circuit, et
$L_e$ est la distance la plus courte entre la portion terminale de la couche de circuit et une portion d'extrémité latérale de la couche conductrice de dissipation de chaleur selon la diagonale sur une face de la couche de circuit du côté couche conductrice de dissipation de chaleur.

4. Dispositif de circuit électronique selon la revendication 2, dans lequel la distance la plus courte $l_1$ entre une portion d'extrémité latérale de l'élément de génération de chaleur et une portion d'extrémité latérale de la couche conductrice de dissipation de chaleur sur une face de la couche conductrice de dissipation de chaleur du côté couche de circuit est inférieure ou égale à quatre fois l'épaisseur $t_1$ de la couche conductrice de dissipation de chaleur.

5. Dispositif de circuit électronique selon l'une quelconque des revendications 1 à 4, dans lequel la face de la couche conductrice de dissipation de chaleur du côté couche de jonction présente une surface inférieure à celle de la face de la couche conductrice de dissipation de chaleur du côté couche de circuit.

6. Dispositif de circuit électronique selon l'une quelconque des revendications 1 à 5, dans lequel la couche conductrice de dissipation de chaleur comporte une première portion conductrice située côté couche de circuit et une deuxième portion conductrice située côté élément de génération de chaleur, et la distance la plus courte $l_2$ entre la portion d'extrémité latérale de l'élément de génération de chaleur et la portion d'extrémité latérale de la deuxième portion conductrice sur une face de la première portion conductrice côté deuxième portion conductrice est supérieure ou égale à deux fois l'épaisseur $t_2$ ($t_2 < t_1$) de la deuxième portion conductrice.

7. Dispositif de circuit électronique selon l'une quelconque des revendications 1 à 6, dans lequel la couche conductrice de dissipation de chaleur présente une conductivité thermique comprise entre 90 et 427 W/(m·K).

8. Dispositif de circuit électronique selon l'une quelconque des revendications 1 à 7, dans lequel la couche conductrice de dissipation de chaleur présente un coefficient de dilatation linéaire compris entre 3 et $18 \times 10^{-6}$/K.

FIG.1

FIG.2

EP 3 093 882 B1

FIG.3

FIG.4

FIG.5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003188316 A

- JP 2001237252 A